# EUROPEAN PATENT SPECIFICATION

(11) **EP 0 477 801 B1**
(45) Date of publication and mention of the grant of the patent: **10.04.1996**
(21) Application number: 91116066.1
(22) Date of filing: 20.09.1991
(51) Int. Cl.: H01L 33/00, H01L 31/0203, H01L 31/02

(54) **Optical semiconductor device**
Optische Halbleiter-Vorrichtung
Dispositif optique à semiconducteur

(30) Priority: 26.09.1990 JP 255601/90
(43) Date of publication of application: 01.04.1992
(73) Proprietor: NEC CORPORATION, Tokyo (JP)
(72) Inventor: Murai, Nobuhiro, c/o NEC Corporation, Minato-ku, Tokyo (JP)
(74) Representative: Pätzold, Herbert, Dr.-Ing.

(56) References cited:
- GB-A- 2 023 928
- GB-A- 2 064 862
- GB-A- 2 192 752
- US-A- 4 642 513
- PATENT ABSTRACTS OF JAPAN vol. 9, no. 230 (E-343)(1953)
- 17 September 1985 & JP- A-60 086 878 ( SUMITOMO DENKI KOGYO KK ) 16 May 1985

## Description

The present invention relates to an optical semiconductor device as mentioned in the preamble of claim 1. More particularly the invention relates to a hermetically sealed optical semiconductor device.

At present, as an amount of information is increased, a large transmission capacity is strongly demanded. In a digital communication field, a communication speed is increasing from 0.6-6b/s modulation to 2.5-6b/s modulation.

Conventionally, as a package coped with the high-speed communication, a thin shell structure had been popular as disclosed in the prior Art GB-A-2 064 862. This structure can reduce a capacitance between terminals and cope with the high-speed communication. However, the structure has the following decisive drawback. That is, the welding thickness is too small to apply stem welding fixation using a laser, and the reliability of fixation cannot be improved.

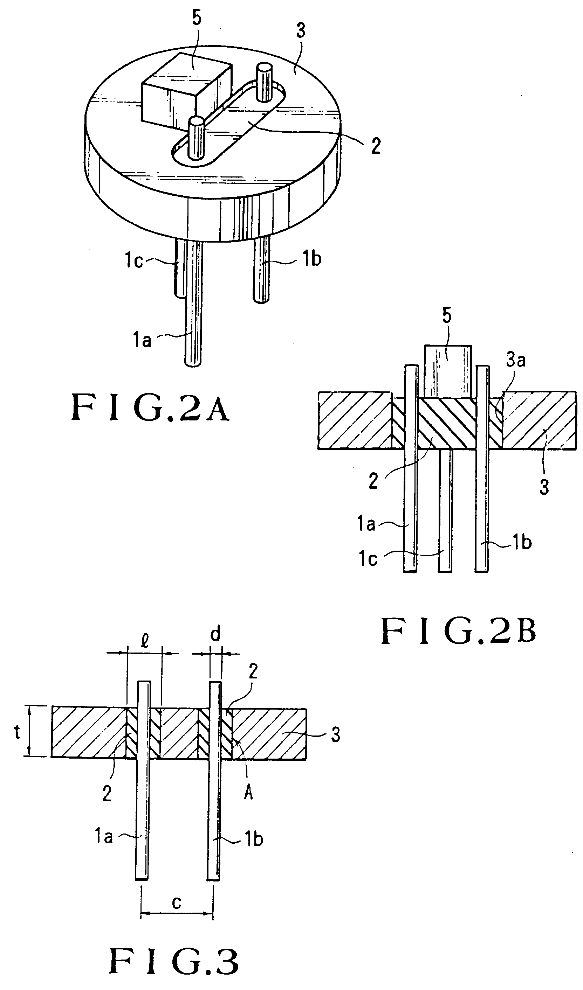

As a package for solving the above drawback, a stem having a thick plate structure as disclosed in the prior art GB-A-2 023 928. This structure is capable of applying laser welding fixation can be used. Fig. 3 is a longitudinal sectional view showing an optical semiconductor device having a thick plate structure. As shown in Fig. 3, the stem has the following structure. That is, lead wires 1a and 1b are hermetically insulated and fixed in a flat metal plate 3 through glass members 2. Each of the glass members 2 is in contact with the flat metal plate 3 on only a side A substantially parallel to the lead wires 1a and 1b, and only one lead wire is fixed in one of the glass members 2 surrounded by one contact side between one of the glass members 2 and the flat metal plate 3.

The glass members 2 are generally made of oxide glass, and the lead wires and the flat metal plate are generally made of iron or a nickel alloy.

In the above conventional semiconductor device, since one lead wire is fixed in a glass member surrounded by one contact side between the glass member and the flat metal plate, the flat metal plate is interposed between the two lead wires hermetically insulated and fixed in the flat metal plate through the glass members. Therefore, when the distance between the lead wires is predetermined, the widths of the glass members located between the lead wires are limited. As a result, a capacitance between the lead wires cannot be reduced, and high-speed modulation cannot be easily performed.

It is an object of the present invention to provide an optical semiconductor device capable of decreasing a capacitance between lead wires.

It is another object of the present invention to provide an optical semiconductor device capable of performing high-speed modulation in optical communication.

In accordance with the present invention, said objects are obtained with the features of the characterizing part of claim 1.

Preferred embodiments of the invention are mentioned in the dependent claims 2 to 4.

### Brief Description of the Drawings

Fig. 1A is a perspective view of the first embodiment of the present invention;
Fig. 1B is a longitudinal sectional view of the first embodiment of the present invention;
Fig. 2A is a perspective view of the second embodiment of the present invention;
Fig. 2B is a longitudinal sectional view of the second embodiment of the present invention;
Fig. 3 is a longitudinal sectional view showing a conventional optical semiconductor device;
Fig. 4A is a plan view of the third embodiment of the present invention;
Fig. 4B is a longitudinal sectional view of the third embodiment of the present invention; and
Fig. 4C is a cross-sectional view of the third embodiment of the present invention;
Fig. 5 is a cross-sectional view showing an optical semiconductor device of Fig. 4B as a whole.

### Description of the Preferred Embodiments

The present invention will be described below with reference to the accompanying drawings.

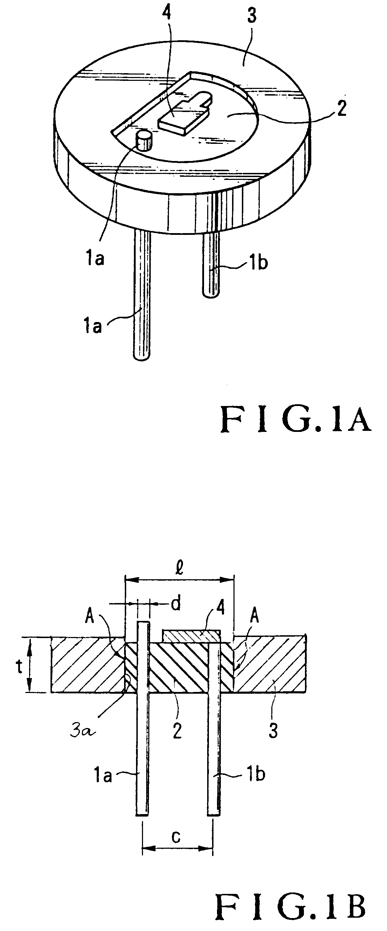

Figs. 1A and 1B show an embodiment of the present invention.

As shown in Figs. 1A and 1B, two lead wires 1a and 1b are bonded to a glass member 2 buried in a through hole 3a of a flat metal plate 3, the glass member 2 is bonded to the inner wall of the through hole 3 on a side A which is substantially parallel to the lead wires 1a and 1b. A metal piece 4 is conductively adhered to the lead wire 1b by electric resistance welding or brazing. The lead wires 1a and 1b are hermetically bonded to the glass member 2, and the glass member 2 is hermetically bonded to the flat metal plate 3. In addition, the glass member 2 electrically insulates the lead wire 1a from the lead wire 1b, and the glass member 2 electrically insulates the lead wires la and 1b from the flat metal plate 3.

A light emitting/receiving element is mounted on the metal piece 4. After the light-emitting or light-receiving element is connected to thin metal wires, it is controlled by an external circuit through the lead wires 1a and 1b.

A cap (not shown) is welded on the upper surface of the flat metal plate 3 by electric resistance welding and hermetically seals an optical semiconductor device constituted by the light-emitting or light-receiving element.

A hermetically sealed semiconductor device according to the present invention includes two lead wires in the same sealing glass although it has a thick plate structure. Therefore, the stem has a high reliability in fixation and can be applied to high-speed modulation.

The unit cost of the stem is the same as that of conventional one, and cost performance can be largely improved.

Figs. 2A and 2B show the second embodiment of the present invention.

In the second embodiment, in place of a metal piece 4, a metal block is conductively adhered to a flat metal plate 3 by brazing or the like. In addition, a laser element is mounted on the side of the metal block 5, connected to lead wires 1a and 1b by thin metal wires, and then driven and controlled by an external circuit.

The second embodiment shows that the present invention can be applied not only to a light-emitting or light-receiving element but to a laser element.

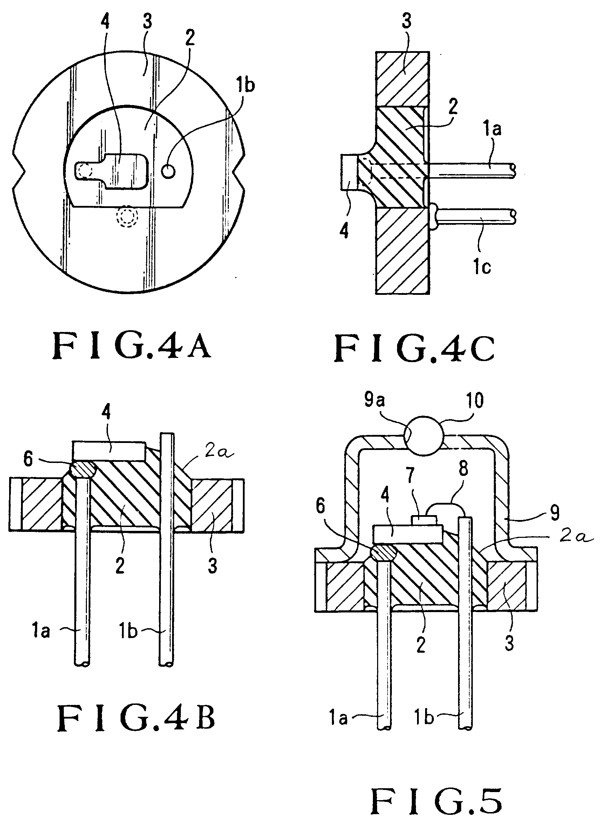

Figs. 4A to 4C show the third embodiment of the present invention. The third embodiment has the same arrangement as that of the first embodiment, and a description thereof will be omitted. Compared with the first embodiment, the upper portion of a glass member 2 having the exposed upper ends of lead wires 1a and 1b is formed into a projecting shape so as to increase the thickness of the glass plate, thereby strongly fixing the lead wires 1a and 1b to the glass member. Note that reference numeral 6 denotes an adhered portion between the lead wire 1a and a metal piece 4.

Fig. 5 is a cross-sectional view showing the optical semiconductor device of Fig. 4B as a whole. A light-receiving element 7 mounted on the metal piece 4 is connected to the lead wire 1b through a bonding wire 8, and a cylindrical cap member 9 is fixed to the metal plate 3 to cover these elements. A lens 10 for converging beams to the light-receiving element 7 is fitted in an opening 9a formed in the top portion of the cap member 9.

As described above, since a stem according to the present invention has a structure in which two or more lead wires are fixed in a glass member surrounded by one contact side between the glass member and a flat metal plate, a capacitance between the two lead wires hermetically insulated and fixed to the flat metal plate through the glass member can be advantageously decreased.

An actual capacitance obtained by the embodiment shown in Figs. 1A and 1B and a cutoff frequency of a frequency response obtained by mounting a light-receiving element on the metal piece 3 are shown in Table 1. Reference symbol ℓ denotes the diameter of the glass portion as shown in Figs. 1B and 3; d, the diameter of each lead wire; c, the distance between the lead wires; and t, the thickness of the flat metal plate.

As shown in Table 1, according to the present invention, the following effects can be obtained. That is, the capacitance can be reduced to 60% of a conventional one, the cutoff frequency can be increased from 1.2 GHz to 3.5 GHz.

**Table 1**

| unit: mm | | | | | | |
|---|---|---|---|---|---|---|
| | ℓ | d | c | t | Capacitance | Cutoff Frequency |
| Present Invention | 3.0 | 0.38 | 2.0 | 1.2 | 0.20 (pF) | 3.5 (GHz) |
| Prior Art | 1.0 | 0.38 | 2.0 | 1.2 | 0.35 (pF) | 1.2 (GHz) |

As apparent from the above description, the present invention is much effective for reducing a capacitance between the lead wires of an optical semiconductor device, and the present invention contributes to future high-speed optical communications.

A chip-carrier package is conventionally used as a high-speed communication response package. A stem package according to the present invention has the following industrial advantages. That is, highly reliable and high-speed communication can be performed, and a higher-speed version of a communication system can be obtained without a change in design of an existing communication system.

## Claims

1. An optical semiconductor device comprising
- a flat metal plate (3) having a through hole in a direction of the thickness of said flat metal plate;
- at least two lead wires (1a, 1b) hermetically insulated from each other and fixed in a single glass member (2);
- an optically semiconductor element (7) electrically connected to said lead wires; and
- a cap member (9) fixed to said metal plate (3) for housing said optical semiconductor element
characterized in that
- said flat metal plate (3) has a thick plate structure;
- said glass member (2) is accomodated in said through hole;
- the outer surface of said glas member (2) is in hermetically bonding contact with the inner side of said through hole of said flat metal plate (3);
- said inner side of said through hole is substantially parallel to said lead wires (1a, 1b) which are electrically insulated from said metal plate

2. An optical semiconductor device according to claim 1, further comprising a metal piece (4), for connecting said optical semiconductor element, mounted to be connected to one of said lead wires (1a, 1b) on an upper surface of said glass member (2) and insulated from said metal plate (3) and said cap member (9)

3. An optical semiconductor device according to claim 1, further comprising a metal block (5) conductively adhered to an upper surface of said flat metal plate (3) and having a side surface on which a laser element ist mounted.

4. An optical semiconductur device according to claim 1, wherein said glass member (2) is formed into a projecting shape (2a) above the upper side of said metal plate (3) so as to strongly fix one of said wires (1b) in said glass member.

## Patentansprüche

1. Optische Halbleitervorrichtung bestehend aus
-- einer flachen Metallplatte (3), die ein durchgehendes Loch in Richtung der Dicke der flachen Metallplatte hat;
-- wenigstens zwei Leitungen (1a, 1b), die hermetisch voneinander isoliert sind und in einem einzelnen Glasteilstück (2) befestigt sind,
-- einem optischen Halbleiterelement (7), das elektrisch mit den beiden Leitungen verbunden ist, und
-- einem Kappenteilstück (9), das an der Metallplatte (3) befestigt ist, um das optische Halbleiterbauelement in einem Gehäuse einzuschließen,
**dadurch gekennzeichnet**, daß
-- die flache Metallplatte (3) eine dicke Plattenstruktur (thick plate structure) hat;
-- das Glasteilstück (2) in dem durchgehenden Loch eingebettet ist;
-- die äußere Oberfläche des Glasteilstückes (2) in hermetisch verbundenem Kontakt mit der inneren Seite des durchgehenden Loches der flachen Metallplatte (3) ist;
-- die innere Seite des durchgehenden Loches im wesentlichen parallel zu den Leitungen (1a, 1b) verläuft, die elektrisch von der Metallplatte isoliert sind.

2. Optische Halbleitervorrichtung nach Anspruch 1, außerdem mit einem Metallstück (4) zur Verbindung des optischen Halbleiterelements, wobei das Metallstück mit einer der Führungsleitungen (1a, 1b) verbunden auf einer oberen Oberfläche des Glasteilstücks (2) fest ist und von der Metallplatte (3) und von dem Kappenteilstück (9) isoliert ist.

3. Optische Halbleitervorrichtung nach Anspruch 1, dadurch gekennzeichnet, daß aus einem Metallblock (5), das leitfähig an einer oberen Oberfläche der flachen Metallplatte (3) geklebt ist und eine Seitenoberfläche hat, auf der ein Lagerelement montiert ist.

4. Optische Halbleitervorrichtung nach Anspruch 1, wobei das Glasteilstück (2) in vorspringender Gestalt (2a) derart über der oberen Seite der Metallplatte (3) herausragt, daß es in verstärktem Maße eine der Führungsleitungen (1b) in dem Glasteilstück hält.

## Revendications

1. Dispositif optique à semiconducteur comprenant :
une plaque métallique plane (3) comportant un trou traversant suivant une direction de l'épaisseur de ladite plaque métallique plane;
au moins deux fils de connexion (1a, 1b) isolés hermétiquement l'un de l'autre et fixés dans un unique élément en verre (2);
un élément optique à semiconducteur (7) connecté électriquement auxdits fils de connexion ; et
un élément de capuchon (9) fixé à ladite plaque métallique (3) pour enfermer ledit élément optique à semiconducteur,
caractérisé en ce que :
ladite plaque métallique plane (3) a une structure plane épaisse;
ledit élément en verre (2) est logé dans ledit trou traversant ;
la surface externe dudit élément en verre (2) est en contact de liaison hermétique avec le côté interne dudit trou traversant de ladite plaque métallique plane (3) ;
ledit côté interne dudit trou traversant est sensiblement parallèle auxdits fils de connexion (1a, 1b) qui sont isolés électriquement de ladite plaque métallique.

2. Dispositif optique à semiconducteur selon la revendication 1, comprenant en outre une pièce métallique (4) pour connecter ledit élément optique à semiconducteur, monté de manière à être connecté à l'un desdits fils de connexion (1a, 1b), sur une surface supérieure dudit élément en verre (2) et de telle sorte qu'elle soit isolée de ladite plaque métallique (3) et dudit élément de capuchon (9).

3. Dispositif optique à semiconducteur selon la revendication 1, comprenant en outre un bloc métallique (5) collé de façon conductrice à une surface supérieure de ladite plaque métallique plane (3) et comportant une surface latérale sur laquelle un élément de laser est monté.

4. Dispositif optique à semiconducteur selon la revendication 1, dans lequel ledit élément en verre (2) est formé selon une forme en protubérance (2a) au-dessus du côté supérieur de ladite plaque métallique (3) de manière à fixer fermement l'un desdits fils de connexion (1b) dans ledit élément en verre.
